(19)

Europäisches
Patentamt
European
Patent Office
Office européen
des brevets

(11) **EP 2 341 613 A1**

(12) **EUROPEAN PATENT APPLICATION**

(43) Date of publication:
06.07.2011 Bulletin 2011/27

(51) Int Cl.:
*H03F 1/32* (2006.01)

(21) Application number: 09180847.7

(22) Date of filing: 29.12.2009

(84) Designated Contracting States:
AT BE BG CH CY CZ DE DK EE ES FI FR GB GR
HR HU IE IS IT LI LT LU LV MC MK MT NL NO PL
PT RO SE SI SK SM TR

(71) Applicant: Nera Networks As
5257 Kokstad (NO)

(72) Inventor: Gjertsen, Karl Martin
5244 FANA (NO)

(74) Representative: Schlossman, Ulf
PATENTOR KB
Flöjelbergsgatan 8B
431 37 Mölndal (SE)

(54) **A detector for nonlinearities**

(57)     A detector (135, 235, 335, 435, 535, 635) for detecting nonlinearities in an amplifier chain, comprising first (130, 230) and second (125, 225) envelope power detectors. The first envelope power detector (130, 230) is provided with a sample of an output signal from the amplifier chain (110, 210) and the second envelope power detector (125, 225) is provided with the sum of a sample of an input signal to the amplifier chain (110, 210) and a sample from the output signal from the amplifier chain (110, 210). Output signals from the first (130, 230) and second (125, 225) envelope power detectors together provide information describing the transfer function of the amplifier chain with its nonlinearities, at a known input signal level to the amplifier chain.

Fig 1

**Description**

TECHNICAL FIELD

The present invention discloses a detector for nonlinearities in an amplifier chain.

BACKGROUND

The performance of high capacity, high spectral efficiency wireless communication equipment such as, for example, transmitter circuits, depends to a large degree on the linearity of the equipment comprised in the transmitter circuit, such as, for example an amplifier in an amplifier chain in the transmitter. Since an amplifier chain's nonlinearity is influenced by the operating conditions of the transmitter circuit, adaptive linearization techniques are especially useful, which in turn creates a need for detectors for nonlinearities in such equipment.

SUMMARY

It is a purpose of the present invention to provide an efficient detector for nonlinearities in an amplifier chain in the transmitter. Such a detector is offered by the present invention in that it discloses a detector for detecting nonlinearities in an amplifier chain. The detector of the invention comprises first and second envelope power detectors; the first envelope power detector is arranged to be provided with a sample of an output signal from the amplifier chain and the second envelope power detector is arranged to be provided with the sum of a sample of an input signal to the amplifier chain and a sample from the output signal from the amplifier chain. The output signals from the first and second envelope power detectors together provide information describing the transfer function of the amplifier chain with its nonlinearities, at a known input signal level to the amplifier chain.

In one embodiment, the detector additionally comprises a control unit which is arranged to receive output signals from the first and second envelope power detectors together with a representation of the envelope power from a signal generator which provides said input signal to the amplifier chain, in order to output a signal which represents the transfer function of the amplifier chain, with its nonlinearities.

In one embodiment of the detector, the control unit is arranged to receive the output of the first envelope power detector synchronized with the representation of the envelope power from the signal generator, and to treat those as being descriptive of the level dependent amplitude gain in the signal from the amplifier.

In one embodiment, the control unit is arranged to also receive the output of the second envelope power detector synchronized with the representation of the envelope power from the signal generator, and to treat those signals together with the level dependent amplitude gain as being descriptive of the level dependent phase shift of the signal from the amplifier.

In one embodiment of the detector, the output of the control unit is provided for use as a correction signal for correcting said nonlinearities.

In one embodiment, the detector additionally comprises a third envelope power detector for detecting the envelope power of the sample of the input to the amplifier chain.

In one embodiment of the detector, the detector comprises phase shifting means for shifting the phase of the sample of the input to the amplifier chain before it is provided to the second or third envelope power detectors, said phase shifting means being controlled by the control unit.

In one embodiment, the detector is equipped with means for one or more of the following:

- Scaling the output signals of the envelope power detectors to set ranges,
- Low Pass Filtering the output signals of the envelope power detectors,
- Converting the output signals of the envelope power detectors to digital representation.

In one embodiment of the detector, one and the same physical envelope power detector is used alternately as one or more of the first, second and third detectors, in which said physical envelope power detector is provided with its input signals from a circuit which is switchable by a switching signal to output either a single input signal as its output signal or to output the sum of two input signals, the switching signal being controlled by the control unit.

The invention also comprises a transmitter circuit which comprises a signal generator coupled to an amplifier chain with at least one amplifier stage, the transmitter circuit also comprising a detector according to any of the embodiments described above.

BRIEF DESCRIPTION OF THE DRAWINGS

The invention will be described in more detail in the following, with reference to the appended drawings, in which

Fig 1 shows a first embodiment of a transmitter circuit of the invention, and
Figs 2-6 show further embodiments of the invention.

DETAILED DESCRIPTION

As mentioned above, the present invention discloses a detector for detecting nonlinearities in an amplifier chain, as well as a transmitter circuit comprising such a detector. In order to describe the invention clearly, an embodiment of a transmitter circuit of the invention will be described in the following. It should however be pointed out that the invention is also directed towards a detector as such.

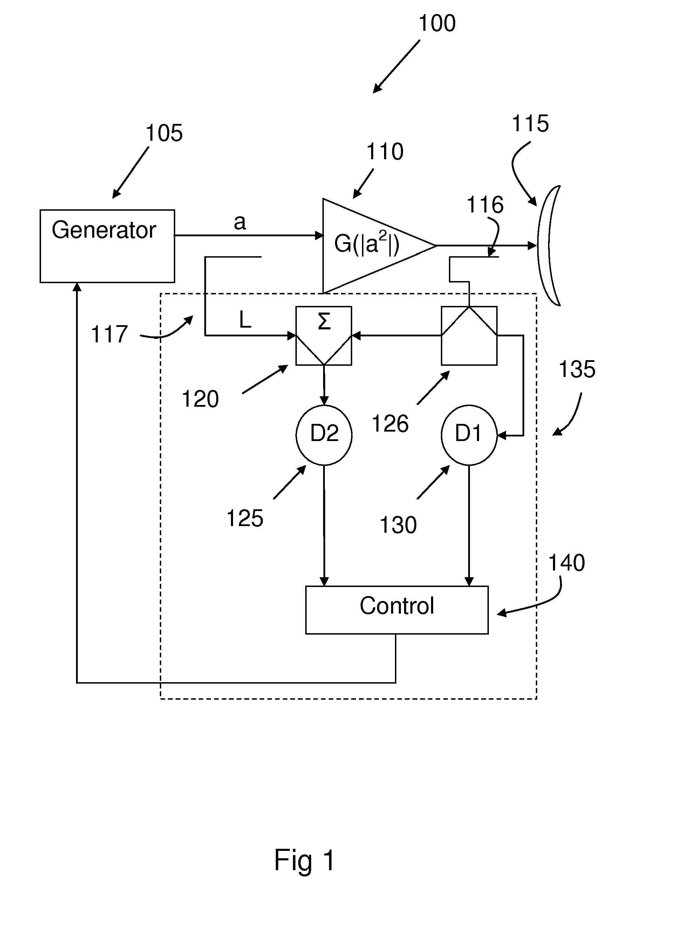

Fig 1 shows a first embodiment 100 of a transmitter circuit of the invention. The transmitter circuit 100 comprises a signal generator 105 coupled to an amplifier chain 110, which comprises one or more amplifiers. Fig 1 shows the amplifier chain 110 as comprising only one amplifier, which is to be seen as an example only. The output from the amplifier chain 110 is symbolically shown as being connected to an antenna 115, which is not comprised in the transmitter circuit 100. In the embodiment 100 of fig 1, the signal generator 105 is a modulator, which is a preferred example of a signal generator, although other kinds of signal generators can also be used in a transmitter circuit of the invention.

As shown in fig 1, and according to the invention, the transmitter circuit 100 comprises a detector 135, indicated with dashed lines in fig 1. The detector 135 comprises a first 130 and a second 125 envelope power detector, which are arranged as follows, which is also indicated in fig 1:

The first envelope power detector 130 is arranged to be provided with a sample of the output signal from the amplifier chain 110, which is suitably done by means of a directional coupler 116, which provides a sample of the output from the amplifier chain 110 to a splitter 126. A first output from the splitter 126 provides the detector 130 with a part of said sample, suitably 50%, although the percentage is a design parameter which can be changed within the scope of the present invention.

As is also shown in fig 1, the second envelope power detector 125 is arranged to be provided with the sum of a sample of the input to the amplifier chain 110 and a sample from the output signal from the amplifier chain 110, the latter being arranged by means of connecting a second output from the splitter 126 to a summation circuit 120.

By means of using a second directional coupler 117, the summation circuit 120 is also provided with a sample with the strength L of the input to the amplifier chain 110. The output from the summation circuit 120 is thus the sum of a sample from the output of the amplifier chain and of a sample of the input to the amplifier chain, a sum which is used as input to the second envelope power detector 125. The first 130 and the second 125 envelope power detectors detect the envelope power of their input signals, i.e. the output signal from the summation circuit 120 in the case of the second detector 125, and in the case of the first detector 130, the first output signal from the splitter 126.

The output signals from the two envelope power detectors 130, 125 reflect the instantaneous envelope power of their respective input signals. The invention capitalizes on this fact in order to detect nonlinearities in the gain function of the amplifier chain, i.e. in the case of the embodiment in fig 1, nonlinearities in the gain function of the amplifier 110. The detection of such nonlinearities according to the invention will be described in more detail in the following:

With reference to fig 1, given the signal "a", i.e. the input from the signal generator 105 to the amplifier 110, the first envelope power detector 135 directly measures the envelope power of the amplifier 110. If we introduce the envelope power P defined as $P=|a^2|$, i.e. the absolute value of the square of a, the expression $|G(P)|$, using $G(P)=G(|a|^2)$, is the amplitude gain from the output of the signal generator (modulator) 105 to the input of the first envelope power detector 130. Consequently, the first envelope detector 135 measures $|G(P)|^2 \cdot P$. Knowing P at the actual time from the generator, $|G(P)|$ is found.

The input signal to the second envelope power detector 125 is, as shown previously, the sum of the sampled signals before and after the amplifier chain 110, here normalized to be $[L + G(P)]a$, where L, as shown previously, is the coupling strength of the signal which is sampled to the summation circuit 120.

The envelope power in the signal $[L + G(P)]$ can be written as:

$$\left|L+G(P)\right|^2 P = \left(\left|L\right|^2 + \left|G(P)\right|^2 + 2\,\mathrm{Re}\!\left(\overline{L}\cdot G(P)\right)\right)\cdot P \qquad [1]$$

The notation $\overline{L}$ is used in [1] to indicate the complex conjugate of L.

The phase difference between the sample of the output from the signal generator 105 and the sample of the amplifier output, i.e. the phase difference between the two inputs to the summation circuit 120 is now known through expression [1] above, and expression [1] above depends on the envelope power P of the signal generator 105 and the envelope power detector outputs, i.e. the "detector readings", assuming that L can be measured when P is known, for example by turning off the amplifier so that we get G(P)=0. In addition, it can be mentioned that if L is known with a sufficient degree of accuracy (said degree being decided by the actual application), measurements of L are of course not needed.

We find explicitly that:

$$\mathrm{Re}\!\left(\overline{L}\cdot G(P)\right) = \cdot \left|L\right|\cdot\left|G(P)\right|\cos\!\left(\angle G(P) - \angle L\right) \qquad [2]$$

Expression [2] above will give a strong and unambiguous response to phase changes in G(P) if the phase of L is selected such that $\angle G(P)$-$\angle L$ varies around $\pm 90$ deg, once the sign of the phase difference is known. The symbol $\angle$ is here used to denote the phase of a signal, i.e. $\angle G$ denotes the phase of the signal G. If, in addition, |L| and |G(P)| are of comparable magnitude, then output from the second detector 125 will show a strong response to phase variation in the amplifier gain. Regarding the term "comparable magnitude", a factor of up to 2 between the two parameters can be seen as a useful range.

By utilizing the envelope power P from the signal generator 105, it is possible to determine variations in $\angle G(P)$.

It can be pointed out that a possible attenuation which is introduced by taking the samples to the detectors 125, 130, does not alter the nonlinear distortion, i.e. the parameter which it is desired to detect by means of the invention.

The detector function as described above assumes that the corresponding envelope power level P is known. One way of achieving this would be to introduce a third detector for measuring the envelope power in the sample L. However, such a solution would add to the hardware cost of the design, which is naturally undesirable. A practical solution is to align the detector measurements in time with the signal from the signal generator 105, which is a qualified measurement of the envelope power. In addition, the signal from the signal generator 105 is usually a digitally generated signal, which simplifies such an alignment. In some embodiments, or rather in some kinds of circuits, the factor L may vary with e.g. frequency and temperature. In such cases, L may need to be kept track of, by means of a solution which will depend on the actual transmitter circuit. However, such solutions are well known to those skilled in the art, and will for that reason not be described here.

Suitably, as shown in fig 1, a transmitter circuit of the invention comprises a control unit 140 which receives as its input the output signals from the first and second envelope power detectors 130, 125 as well as the envelope power P from the generator 105, the control unit 140 being arranged to use these input signals in order to output a signal which is used to represent the transfer function of the amplifier chain. As is indicated in fig 1 by means of an arrow from the control unit 140 to the signal generator 105, the generator 105 as such can be arranged to receive an output signal representing the detector readings D1 and D2 from the control unit 140, in which case the signal generator 105 is arranged to use that output signal together with its own envelope power P according to the principles of expressions [1] and [2] above in order to determine the transfer function of the amplifier chain, seen as the complex gain function G(P) over the dynamic range of P in the amplifier chain 110.

Alternatively, the arrow from the signal generator 105 to the control unit can also function P from the in the other direction, i.e. control unit 140 receives a signal representing the envelope power signal generator, and the control unit is in that case arranged to function according to expressions [1] and [2] above in order to detect and determine in the transfer function of the amplifier chain, seen as the complex gain function G(P) over the dynamic range of P in the amplifier chain 110.

In such an embodiment, the output from the control unit can then be used directly in order to compensate for or to correct nonlinearities in the amplifier chain, as an alternative to which the control unit is also arranged to carry out such compensation and/or correction, something which however is not within the scope of the present invention.

A further observation is that the data obtained by means of the envelope power from the generator 105 and the first 130 and second 125 envelope power detector provide simultaneous amplitude and phase detection of the transfer function G(P) between the points for the two "probes", in this case the two directional couplers 116, 117. Using this observation, it is possible to extract sample-by-sample values for both amplitude and phase of G(P), which enables the use of a wide range of algorithms for adaptive compensation or correction of the observed nonlinearity.

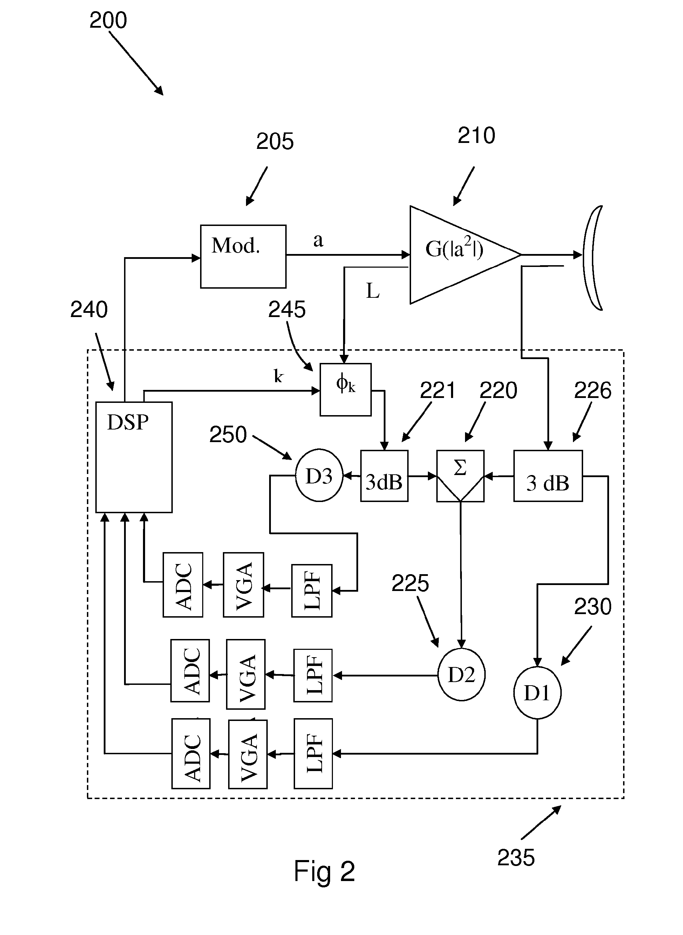

A further embodiment of a transmitter circuit 200 with a detector 235 of the present invention is shown in fig 2. As an option, a third detector 250 has been introduced here, in order to detect the absolute value of L, i.e. |L|, which in turn enables observation of the input envelope power P.

In further addition to the embodiment 135 of fig 1, the embodiment 235 of fig 2 comprises a circuit 245 for phase shift of the sample L at the input to the amplifier 210. The output from the phase shifter 245 is then connected to a second splitter 221, here shown as a "3dB" splitter, which is of course only an example of the split factor. The second splitter 221 connects to the third detector 250, mentioned above, and to a summation circuit 220, which corresponds to the summation circuit 120 of fig 1.

As with the embodiment of fig 1, the embodiment 235 comprises a first 230 and a second 225 envelope power detector, which measure the parameters mentioned in connection to the description of the embodiment 100 of fig 1. The embodiment 235 comprises a first splitter 226, here shown as a "3dB" splitter, which is of course only an example of the split factor. The first splitter 226 corresponds to the splitter 126 of fig 1.

In correspondence to the control unit 140 of fig 1, the embodiment 235 of fig 2 comprises a Digital Signal Processor, DSP, 240, which receives the output signals for the three detectors 250, 225, 230, and which uses the signals from the detectors in order to detect in the transfer function of the amplifier (chain) 210 in the manner described previously, i.e. in this case the nonlinearities in the transfer function. The DSP 240 is also connected to a signal generator 205, which in this case is a modulator, thereby illustrating a possible use of the invention for detecting predistortion nonlinearity in the amplifier chain.

As shown in fig 2, the DSP 240 also serves to control the phase shift value k of the phase shifter 245. The value k of the phase shift is suitably determined by the DSP 240 by means of expression [2] above, in which the proper phase angle is found by means of the cosine function.

As is also shown in fig 2, the output from each of the three detectors 230, 225, 250 is put through a Low Pass Filter, LPF, connected to a VGA, Voltage Gain Amplifier, and then converted to digital form in an analogue-to-digital converter, an ADC. The VGAs are used in order to condition the signals to the dynamic ranges of the ADC's. They are controlled by the DSP, which scales the digital readings from the detectors by the applied gain in the VGAs to reestablish comparable readings of the three detectors.

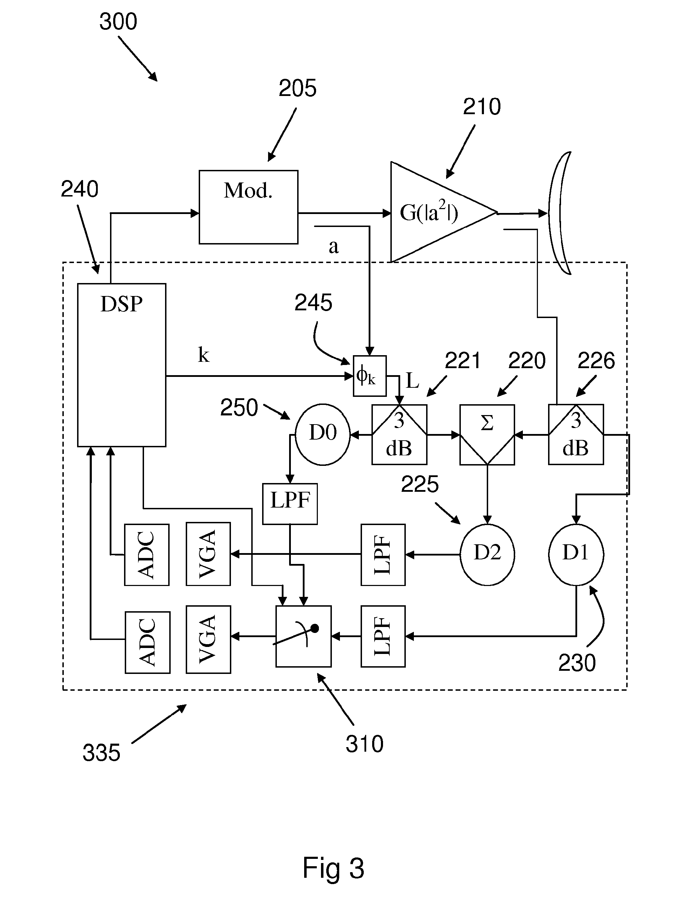

Fig 3 shows a simplified embodiment 335 of the non linearity detector 235 of fig 2, connected to a signal generator 205 and an amplifier chain comprising a single amplifier 210. Due to the similarities between the embodiments 235 and 335, the reference numbers of embodiment 235 have been retained in fig 3. However, as opposed to the embodiment 235, the embodiment 335 is one which can be used if there is no need for continuous observation of the envelope power detector 250, which is the case if the output data from the detectors are synchronized with the input signal to the amplifier 210. Here the DSP 240 provides the signal to the modulator 205. If that is the case, it is only necessary with sampling of the detector 250 to maintain a precise scaling factor for the transfer from a digital output signal to the signal reaching the detector 250. This allows "multiplex" use of an ADC that intermittently reads the output from the detector 250 instead of the detector 230, as shown in fig 3, which is accomplished by means of a switch 310 which is controlled by the DSP 240.

The embodiment of fig 3 is suitable for minimizing the relative error between readings of |L| and |G(P)| while protecting the signal path from switch transients.

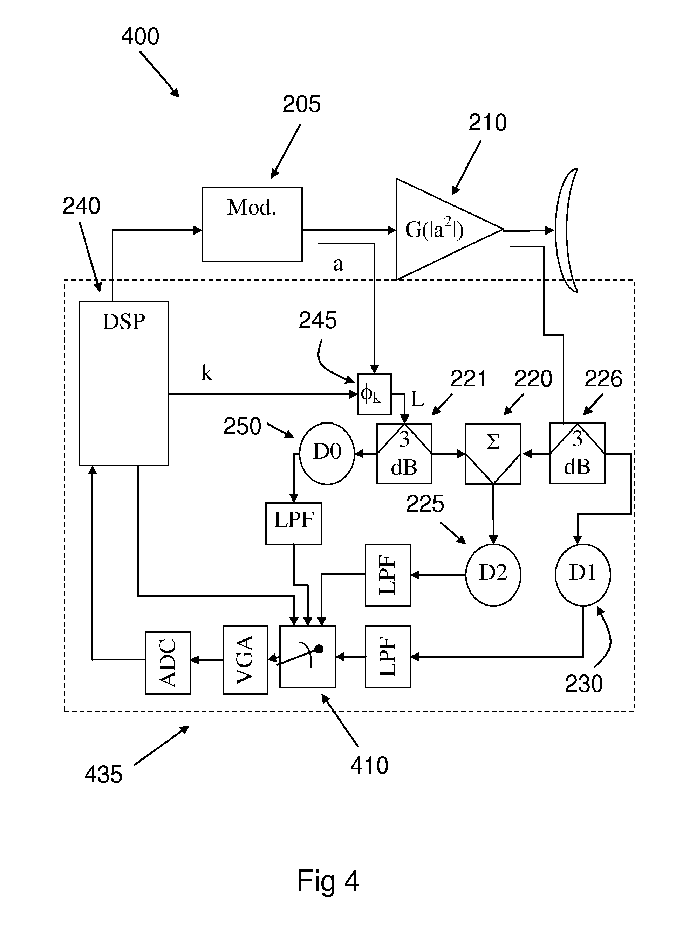

Fig 4 shows a further simplified embodiment 435 of a non linearity detector of the invention, connected to a signal generator 205 and an amplifier chain comprising a single amplifier 210. In fig 4, the reference numbers of figs 2 and 3 have been retained due to general technical similarities: However a principle which is illustrated by means of the embodiment 435, shown in fig 4, is that if a slower update of the nonlinearity model is acceptable, it is possible to multiplex the signals from all three detectors 250, 225, 230, into one single ADC, exploiting the synchronization of the detectors with the digital output signal. Samples of the output of the detector 250 are still used in this embodiment in order to measure the linear gain from digital data to detector L, while samples of the envelope power detector 230 provide data for a description of |G(P)|.

Interpretation of samples from the envelope power detector 225 requires a sufficient quality of |G(P)|, requiring a batch-like processing where possibly interpolated values of |G(P)| are used together with samples from the envelope power detector 225 in order to generate $\angle G(P)$.

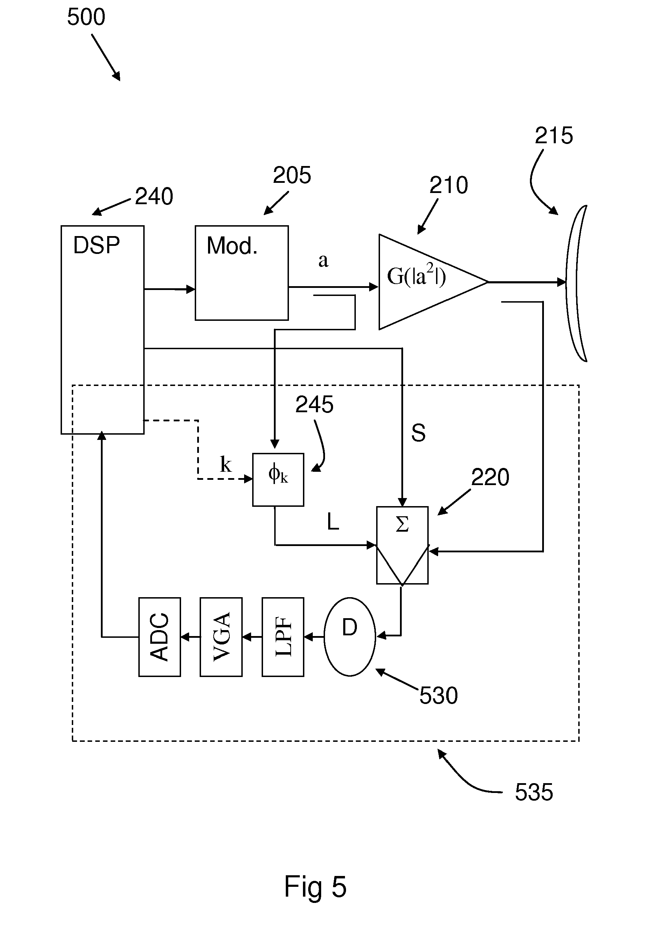

Fig 5 shows yet a further embodiment 500 of a detector 535 of the invention, connected to a modulator 205 controlled from the DSP 240 and an amplifier chain comprising at least one amplifier 210. However, the embodiment 535 is intended to show that it is possible to further reduce the design complexity of the detector if switching can be accepted close to the signal path: in such a case, it is, as shown in fig 5, possible to utilize the summation circuit 220 in order to enable routing through that circuit of either the signal L, the signal G(P), or the sum of the two to a common detector D 530.

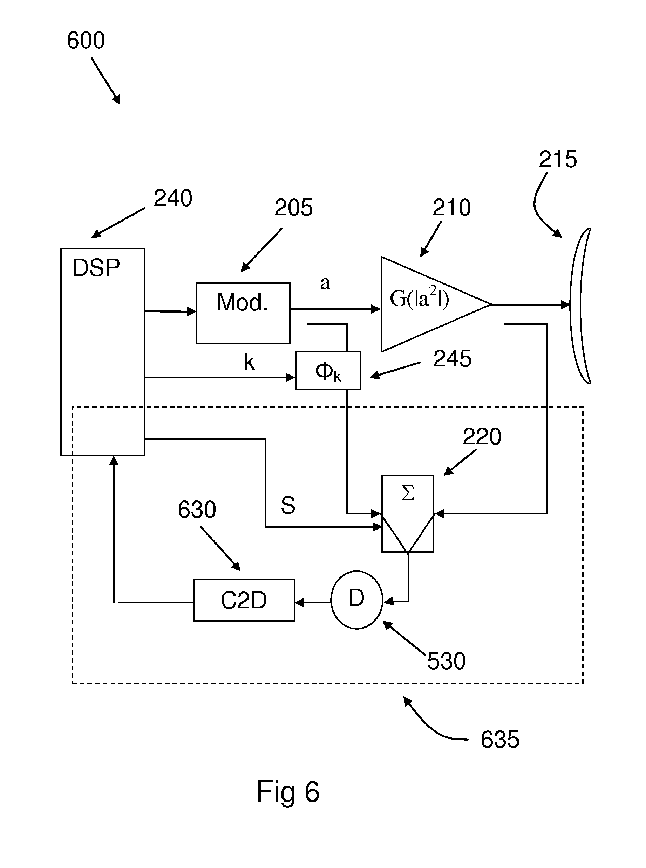

Fig 6 shows a further embodiment 600 of the invention. As seen in fig 6, the embodiment 600 is similar to the embodiment of fig 5, for which reason the reference numbers of fig 5 have been retained, with the exception of the nonlinearity detector which has been numbered as 635 in fig 6.

A difference between the embodiment 600 of fig 6 and those of figs 2-5, is that the LPF-VGA-ADC chain through which the output from the envelope power detector or detectors of figs 2-5 is passed before being input to the DSP 240 has been replaced with a single circle 630, a C2D, "conversion to digital representation. This alternative is made to symbolically show that any implementation which gives a sufficiently precise digital reading of the detector output may be used.

The embodiment 600 of fig 6 comprises one envelope power detector, which receives its input from a "switched" summation circuit 220, which is switched by a signal S from the DSP 240, as has also been described above in connection to fig 5. However, the principle of substituting the chain of LPF-VGA-ADC can of course be applied to any of the embodiments of the invention, such as those of figs 2-5.

The invention is not limited to the examples of embodiments described above and shown in the drawings, but may be freely varied within the scope of the appended claims.

**Claims**

1. A detector (135, 235, 335, 435, 535, 635) for detecting nonlinearities in an amplifier chain, the detector comprising first (130, 230) and second (125, 225) envelope power detectors, the detector being **characterized in that** the first envelope power detector (130, 230) is arranged to be provided with a sample of an output signal from the amplifier chain (110, 210) and the second envelope power detector (125, 225) is arranged to be provided with the sum of a sample of an input signal to the amplifier chain (110, 210) and a sample from the output signal from the amplifier chain (110, 210), with output signals from the first (130, 230) and second (125, 225) envelope power detectors together providing information describing the transfer function of the amplifier chain with its nonlinearities, at a known input signal level to the amplifier chain.

2. The detector (135, 235, 335, 435, 535, 635) of claim 1, additionally comprising a control unit (140, 240), the control unit being arranged to receive output signals from the first (130, 230) and second (125, 225) envelope power detectors together with a representation of the envelope power from a signal generator which provides said input signal to the amplifier chain, in order to output a signal which represents the transfer function of the amplifier chain, with its nonlinearities.

3. The detector (135, 235, 335, 435, 535, 635) of claim 2, in which the control unit (140, 240) is arranged to receive the output of the first envelope power detector (130) synchronized with the representation of the envelope power from the signal generator (105, 205), and to treat those as being descriptive of the level dependent amplitude gain in the signal from the amplifier (110).

4. The detector (135, 235, 335, 435, 535, 635) of claim 3, in which the control unit (140, 240) is arranged to also receive the output of the second envelope power detector (125) synchronized with the representation of the envelope power from the signal generator (105, 205), and to treat those signals together with the level dependent amplitude gain as being descriptive of the level dependent phase shift of the signal from the amplifier.

5. The detector (135, 235, 335, 435, 535, 635) of any of claims 1-4, in which the output of the control unit (140, 240) is provided for use as a correction signal for correcting said nonlinearities.

6. The detector (235, 335, 435, 535, 635) of any of the previous claims, additionally comprising a third envelope power detector (250) for detecting the envelope power of the sample of the input to the amplifier chain.

7. The detector (235, 335, 435, 535, 635) of any of claims 1-6, in which the detector comprises phase shifting means (245) for shifting the phase of the sample of the input to the amplifier chain before it is provided to the second or third envelope power detectors, said phase shifting means being controlled by the control unit (240).

8. The detector (235, 335, 435, 535, 635) of any of the previous claims, being equipped with means for one or more of the following:

- Scaling the output signals of the envelope power detectors to set ranges,
- Low Pass Filtering the output signals of the envelope power detectors,

- Converting the output signals of the envelope power detectors to digital representation.

9. The detector (635) of any of the previous claims, in which one and the same physical envelope power detector (530) is used alternatingly as one or more of the first, second and third detectors, in which said physical envelope power detector is provided with its input signals from a circuit which is switchable by a switching signal (S) to output either a single input signal as its output signal or to output the sum of two input signals, said switching signal (S) controlled by the control unit (240).

10. A transmitter circuit (100, 200, 300, 400, 500, 600) comprising a signal generator (105, 205) coupled to an amplifier chain (110, 210) with at least one amplifier stage, the transmitter circuit (100, 200, 300, 400, 500, 600) also comprising a detector (135, 235, 335, 435, 535, 635) according to any of the previous claims for detecting nonlinearities in the amplifier chain.

Fig 1

Fig 2

Fig 3

Fig 4

500

240

205

210

215

DSP

Mod.

a

$G(|a^2|)$

245

k

$\phi_k$

S

220

L

$\Sigma$

ADC

VGA

LPF

D

530

535

Fig 5

Fig 6

Europäisches
Patentamt

European
Patent Office

Office européen
des brevets

**EUROPEAN SEARCH REPORT**

Application Number

EP 09 18 0847

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 03/081870 A1 (CANADA MAJESTY IN RIGHT OF [CA]; HUANG XINPING [CA]; CARON MARIO [CA]) 2 October 2003 (2003-10-02) * page 17, paragraph 0076; figure 14c * | 1 | INV. H03F1/32 |
| A | US 7 362 818 B1 (SMITH HOWARD J [GB] ET AL) 22 April 2008 (2008-04-22) * column 4, line 43 - column 5, line 26; figures 1,2 * | 1,9 | |
| A | US 6 496 062 B1 (NITZ WILLIAM ALLEN [US] ET AL) 17 December 2002 (2002-12-17) * paragraph [0020] - paragraph [0023]; figure 2 * | 1 | |

TECHNICAL FIELDS
SEARCHED      (IPC)

H03F

The present search report has been drawn up for all claims

| Place of search | Date of completion of the search | Examiner |
|---|---|---|
| The Hague | 21 April 2010 | Van den Doel, Jules |

EPO FORM 1503 03.82 (P04C01)

## ANNEX TO THE EUROPEAN SEARCH REPORT
## ON EUROPEAN PATENT APPLICATION NO.

EP 09 18 0847

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2010

| Patent document cited in search report | | Publication date | Patent family member(s) | | Publication date |
|---|---|---|---|---|---|
| WO 03081870 | A1 | 02-10-2003 | AU<br>CA<br>EP | 2003213930 A1<br>2457404 A1<br>1402700 A1 | 08-10-2003<br>02-10-2003<br>31-03-2004 |
| US 7362818 | B1 | 22-04-2008 | NONE | | |
| US 6496062 | B1 | 17-12-2002 | NONE | | |

EPO FORM P0459

For more details about this annex : see Official Journal of the European Patent Office, No. 12/82